# DEMANDE DE BREVET EUROPEEN

(11) **EP 2 190 023 A1**
(43) Date de publication de la demande: **26.05.2010**
(21) Numéro de dépôt: 08169423.4
(22) Date de dépôt: 19.11.2008
(51) Int. Cl.: H01L 31/0236, H01L 31/078

(54) **Dispositif photoéléctrique à jonctions multiples et son procédé de réalisation**

(71) Demandeur: Université de Neuchâtel, 2000 Neuchatel (CH)
(72) Inventeur: Söderström Thomas, 1026, Denges (CH); Haug, Franz-Joseph, 2072, Saint-Blaise (CH); Niquille, Xavier, 2000, Neuchâtel (CH)
(74) Mandataire: GLN

(57) **Abrégé**

La présente invention concerne un dispositif photoélectrique (1) à jonctions multiples comprenant un substrat (2) sur lequel est déposée une première couche conductrice (3), au moins deux dispositifs photoélectriques élémentaires (4, 6) de configuration n-i-p ou n-p, sur lesquels est déposée une seconde couche conductrice (7), et au moins une couche intermédiaire (5) prévue entre deux dispositifs photoélectriques élémentaires adjacents (4, 6).

Selon l'invention, la couche intermédiaire (5) présente, du côté de la lumière entrant, une face supérieure (10) et de l'autre côté, une face inférieure (11), les dites faces supérieure (10) et inférieure (11) présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ est l'angle pour lequel 90% des surfaces élémentaires de la face supérieure (10) de la couche intermédiaire (5) présentent une inclinaison inférieure ou égale à cet angle, et α_{90inf} est l'angle pour lequel 90% des surfaces élémentaires de la face inférieure (11) de la couche intermédiaire (5) présentent une inclinaison inférieure ou égale à cet angle.

## Description

### Domaine technique

La présente invention se rapporte au domaine des dispositifs photoélectriques. Elle concerne, plus particulièrement, un dispositif photoélectrique composé de cellules élémentaires de configuration n-i-p ou n-p, empilées les unes sur les autres, qui absorbent la lumière sur des gammes de longueurs d'onde différentes. De tels dispositifs sont appelés cellules à jonctions multiples. L'invention concerne également un procédé de réalisation de ce dispositif photoélectrique.

La présente invention trouve une application particulièrement intéressante pour la réalisation de cellules photovoltaïques destinées à la production d'énergie électrique, mais elle s'applique également, de manière plus générale, à toute structure dans laquelle un rayonnement lumineux est converti en un signal électrique, telle que les photodétecteurs.

### Etat de la technique

Classiquement, une cellule double jonction ou tandem en couche minces de silicium est constituée d'une cellule supérieure en silicium amorphe, qui absorbe la lumière visible (jusqu'à environ 750 nm) et d'une cellule inférieure en silicium microcristallin qui absorbe la lumière jusque dans l'infrarouge (jusqu'à 1100 nm environ). Une telle cellule est appelée cellule "Micromorph". Dans la présente description, "supérieur" signifie le côté proche de la lumière incidente, et "inférieur" signifie le côté éloigné de la lumière incidente.

Pour augmenter le courant, dans une cellule simple comme dans une cellule à jonction multiple, le contact arrière est rugueux afin de diffuser la lumière dans le dispositif. Une surface rugueuse est constituée d'une succession de bosses et de creux formés de surfaces élémentaires plus ou moins inclinées. La morphologie de la surface du substrat joue un rôle primordial dans les performances optiques (déterminées par le courant de court-circuit (Jcc)) et électriques (tension de circuit ouvert (Vco) et facteur de forme (FF)), i.e. l'efficacité, de la cellule solaire.

En ce qui concerne les cellules microcristallines, une telle cellule a de meilleures caractéristiques électriques (meilleurs facteurs de forme (FF) et tension de circuit ouvert (Vco)) si elle est déposée sur un substrat sans ou comprenant peu de surfaces élémentaires fortement inclinées. Cependant, les surfaces élémentaires fortement inclinées des interfaces favorisent la diffusion de la lumière dans la cellule. Ainsi, les caractéristiques optiques de la cellule (courant de court-circuit (Jcc)) sont améliorées. Dès lors, la morphologie optimale est un compromis entre les caractéristiques électriques et optiques de la cellule solaire.

En ce qui concerne les cellules amorphes, les caractéristiques électriques de la cellule amorphe ne souffrent pas ou peu d'une morphologie de substrat présentant des surfaces élémentaires fortement inclinées. Cependant, elle souffre d'une dégradation de l'efficacité lors de son exposition à la lumière. Le moyen de limiter la dégradation est de diminuer l'épaisseur de la cellule. Afin de diminuer l'épaisseur de la cellule et de conserver de bonnes efficacités, on utilise des substrats avec des surfaces élémentaires fortement inclinées qui augmentent la diffusion de la lumière dans la cellule.

Dans une cellule tandem ou multi-jonction, le problème consiste à augmenter le courant dans les cellules en utilisant des surfaces rugueuses qui diffusent la lumière. Cependant, les morphologies optimales pour les cellules supérieures et inférieures sont différentes. En effet, la cellule supérieure nécessite une morphologie de substrat présentant des surfaces élémentaires fortement inclinées afin d'augmenter son courant, de réduire son épaisseur et ainsi de limiter sa dégradation. Néanmoins, sur ce type de morphologie, la cellule microcristalline inférieure souffre d'une morphologie inadaptée, ce qui se manifeste dans la cellule tandem par les mêmes symptômes que dans une cellule simple : une chute du facteur de forme FF et de la tension de circuit ouvert Vco. De plus, la croissance de la cellule inférieure aplanit la structure donnée par le substrat ce qui rend la texture inefficace pour la cellule supérieure.

Pour pallier ce problème, il a été proposé de placer un miroir intermédiaire (50-150 nm) entre la cellule supérieure et la cellule inférieure, permettant d'augmenter le courant de la cellule supérieure. Un miroir intermédiaire est une couche intercalée entre deux cellules élémentaires avec un indice de réfraction (n) inférieur aux indices de réfraction des cellules élémentaires. Pour une cellule "Micromorph", un tel miroir intermédiaire avec un indice de réfraction (n) typiquement entre 1.3 à 2.5 est intercalé entre la cellule supérieure et la cellule inférieure. Ceci permet d'augmenter le courant de la cellule supérieure sans avoir à augmenter son épaisseur, ce qui minimise l'effet de la dégradation de la cellule supérieure sous illumination.

Cependant, la morphologie de surface de la cellule inférieure sur laquelle on dépose le miroir intermédiaire est très similaire à la surface du miroir intermédiaire déposé. En d'autres termes, le dépôt du miroir intermédiaire reproduit la morphologie de surface de la cellule inférieure et ne permet pas de changer la morphologie pour produire une morphologie adaptée à la croissance de la cellule supérieure.

Les brevet US 6,825,408 et US 6,459,034 décrivent l'utilisation, entre la cellule supérieure et la cellule inférieure, d'une couche intermédiaire présentant des surfaces irrégulières de hauteurs différentes, la surface du côté de la cellule inférieure ayant une différence de hauteur moyenne supérieure à celle de la surface du côté de la cellule supérieure.

Toutefois, ces critères de hauteur ne permettent pas non plus d'obtenir les morphologies de surface optimales pour les deux cellules. En effet, cela permet certes d'augmenter le pourcentage de lumière entrant dans le dispositif, mais le gain en efficacité n'est pas encore suffisant.

Un but de la présente invention est donc de pallier ces inconvénients, en proposant un dispositif photoélectrique plus performant, présentant des morphologies de surface optimales pour les deux cellules.

### Divulgation de l'invention

A cet effet, et conformément à la présente invention, il est proposé un dispositif photoélectrique à jonctions multiples comprenant un substrat sur lequel est déposée une première couche conductrice, au moins deux dispositifs photoélectriques élémentaires de configuration n-i-p ou n-p, sur lesquels est déposée une seconde couche conductrice, et au moins une couche intermédiaire prévue entre deux dispositifs photoélectriques élémentaires adjacents, ladite couche intermédiaire présentant, du côté de la lumière entrant, une face supérieure et de l'autre côté, une face inférieure, les dites faces supérieure et inférieure présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et plus préférentiellement encore supérieure ou égale à 15°; où α₉₀ₛᵤₚ est l'angle pour lequel 90% des surfaces élémentaires de la face supérieure de la couche intermédiaire présentent une inclinaison inférieure ou égale à cet angle, et α_{90inf} est l'angle pour lequel 90% des surfaces élémentaires de la face inférieure de la couche intermédiaire présentent une inclinaison inférieure ou égale à cet angle.

De telles morphologies de surface permettent de concilier de manière optimale les morphologies requises par chacune des faces de la couche intermédiaire, et d'obtenir ainsi un dispositif plus performant.

La présente invention concerne également un procédé de réalisation d'un dispositif photoélectrique à jonctions multiples comprenant un substrat sur lequel est déposée une première couche conductrice, au moins deux dispositifs photoélectriques élémentaires de configuration n-i-p ou n-p, sur lesquels est déposée une seconde couche conductrice. Selon l'invention, le procédé comprend une étape de dépôt, sur au moins l'un desdits dispositifs photoélectriques élémentaires, d'une couche intermédiaire présentant, du côté de la lumière entrant, une face supérieure et de l'autre côté, une face inférieure, les dites faces supérieure et inférieure présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et plus préférentiellement encore supérieure ou égale à 15°; où α₉₀ₛᵤₚ et α_{9oinf} sont définis ci-dessus.

Les étapes essentielles du procédé comprennent la croissance de la couche intermédiaire déposée sur le dispositif photoélectrique élémentaire du côté du substrat. Les surfaces élémentaires fortement inclinées de la face supérieure de la couche intermédiaire sont obtenues soit en une étape par le dépôt qui permet une croissance d'une couche intermédiaire avec, en surface, des surfaces élémentaires fortement inclinées soit en deux étapes qui comprennent la croissance de la couche intermédiaire et un traitement qui permet de former les surfaces élémentaires fortement inclinées.

### Brève description des dessins

D'autres caractéristiques de la présente invention apparaîtront plus clairement à la lecture de la description qui va suivre, faite en référence aux dessins annexés, dans lesquels:
- la figure 1 représente un schéma d'une cellule tandem selon l'invention,
- la figure 2 représente un schéma illustrant le calcul de l'angle d'inclinaison de la surface au point A d'une image obtenu par microscope à force atomique (AFM),
- la figure 3 représente l'intégrale de la distribution angulaire des faces supérieure et inférieure de la couche intermédiaire dans un dispositif selon l'invention, et
- la figure 4 représente le rendement quantique externe des cellules inférieure et supérieure sans miroir, avec miroir standard et avec la couche intermédiaire selon la présente invention.

### Mode(s) de réalisation de l'invention

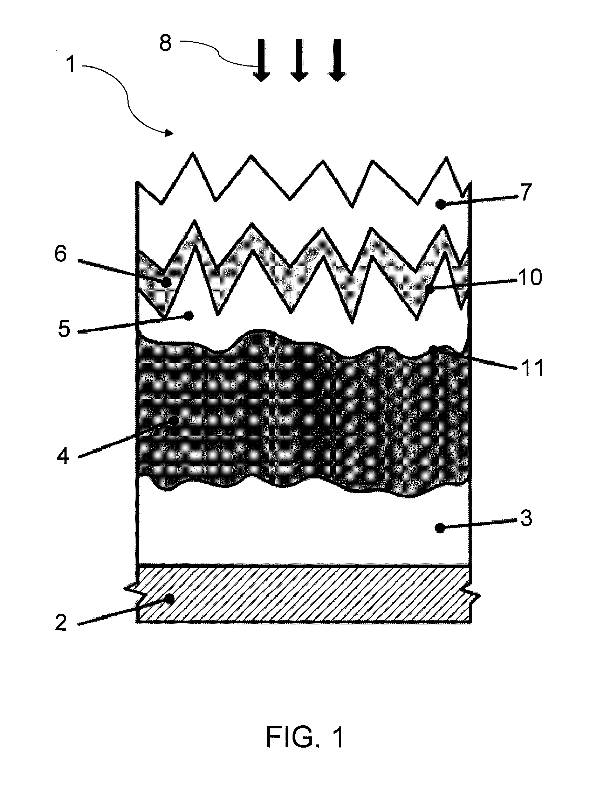

En référence à la figure 1, il est représenté un dispositif photoélectrique ou une cellule "Micromorph" 1 comprenant, empilés les uns sur les autres, un substrat 2, une première couche conductrice 3, constituant une première électrode, un premier dispositif photoélectrique élémentaire 4, appelé cellule inférieure, une couche intermédiaire 5, un second dispositif photoélectrique élémentaire 6, appelé cellule supérieure, et une seconde couche conductrice 7 transparente, constituant une seconde électrode. Le dispositif 1 est exposé à la lumière orientée selon les flèches 8.

La couche intermédiaire 5 présente, du côté de la lumière entrant, une face supérieure 10 et de l'autre côté, une face inférieure 11.

Selon l'invention, lesdites faces supérieure 10 et inférieure 11 présentent respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et plus préférentiellement encore supérieure ou égale à 15°; où α₉₀ₛᵤₚ est l'angle pour lequel 90% des surfaces élémentaires de la face supérieure de la couche intermédiaire présentent une inclinaison inférieure ou égale à cet angle, et α_{90inf} est l'angle pour lequel 90% des surfaces élémentaires de la face inférieure de la couche intermédiaire présentent une inclinaison inférieure ou égale à cet angle.

Par exemple, la différence entre α₉₀ₛᵤₚ et α_{90inf} peut être comprise entre 3° et 60°, préférentiellement comprise entre 6° et 25°, et plus préférentiellement encore comprise entre 10° et 15°.

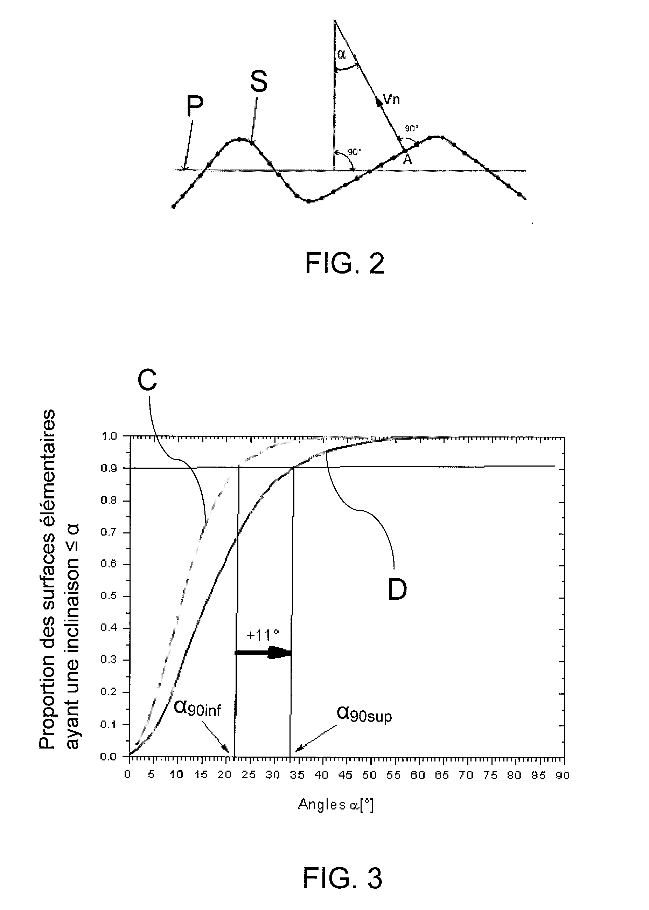

En référence à la figure 2, la morphologie de la surface est décrite ici par les inclinaisons des surfaces élémentaires composant la surface rugueuse de l'échantillon, aussi appelée distribution angulaire de la surface. Pour ce faire, on réalise une mesure AFM sur une surface de 5 µm * 5 µm correspondant à une matrice de 256 * 256 points équidistants (axes x et y dans le système de coordonnés traditionnel) qui représente la topologie (axe z) de la surface de l'échantillon. Afin d'éliminer une éventuelle inclinaison ou courbure du substrat, on soustrait de cette image le polynôme d'ordre 2 qui minimise la somme des écarts au carré entre celui-ci et la surface. On obtient ainsi une bonne représentation de la morphologie de la surface S qui est typiquement constituée de structures de tailles entre 50 et 2000 nm. Le plan z=0 est défini comme étant le plan horizontal P.

Pour obtenir la distribution angulaire des surfaces, on calcule, pour chaque point A de l'image AFM, l'angle entre le vecteur normal au plan horizontal P et le vecteur Vn normal à la surface S. Pour ce faire, la surface élémentaire considérée pour calculer la normale au point A est définie par le point A et deux vecteurs Vx et Vy. Vx est le vecteur qui relie les deux points (proches voisins dans la matrice AFM) avant et après le point A dans la direction x et Vy est le vecteur qui relie les deux points (proches voisins dans la matrice AFM) avant et après le point A dans la direction y. Le vecteur normal Vn à la surface élémentaire considérée est déterminé par le produit vectoriel de Vx et Vy. L'angle d'inclinaison α de la surface élémentaire est défini comme étant l'angle entre le vecteur normal Vn de la surface élémentaire considérée et le vecteur normal au plan horizontal P.

On peut construire une nouvelle matrice de point représentant l'inclinaison de chaque surface élémentaire en chaque point de la matrice AFM. A partir de la matrice qui indique l'inclinaison à chaque point de la surface, on peut faire un histogramme des angles de 0 à 90° (distribution angulaire) qui donne la proportion de la surface qui a une inclinaison compris dans un certain intervalle d'angles (typiquement 2 degrés). En intégrant celui-ci on obtient l'intégrale de la distribution angulaire (cf. Figure 3). Les angles sont représentés en abscisse. En ordonnée est représentée la proportion des surfaces élémentaires présentant une inclinaison égale ou inférieure à un angle donné. Une surface horizontale et plate est définie comme n'ayant que des surfaces élémentaires présentant une inclinaison selon un angle égal à 0°, et donc l'intégrale de la distribution angulaire est égale à 1 entre 0° et 90°. Par contre une surface extrêmement rugueuse, avec des surfaces élémentaires fortement inclinées, montre une distribution angulaire avec une grande proportion de surfaces élémentaires présentant des inclinaisons élevées et donc l'intégrale de la distribution angulaire est proche de 0 pour les petits angles (ex : 0°-15°) et est proche de 1 seulement pour les grands angles (ex : 30°-70°).

Dans la présente invention, pour caractériser la morphologie d'une surface, la valeur α considérée est l'angle α₉₀ pour lequel 90% des surfaces élémentaires de la surface étudiée présentent une inclinaison inférieure ou égale à cet angle.

De préférence, l'angle α₉₀ₛᵤₚ est compris entre 25° et 60°.

De préférence, l'angle α_{90inf} est compris entre 0° et 25°.

Le substrat 2 peut être réalisé dans un matériau choisi parmi le groupe comprenant les matières plastiques (par exemple PEN, PET, polyimide), le verre, un métal (par exemple un acier), le silicium ou autres matériaux résistant aux conditions de fabrication de la cellule solaire (cf. J. Bailat, V. Terrazzoni-Daudrix, J. Guillet, F. Freitas, X. Niquille, A. Shah, C. Ballif, T. Scharf, R. Morf, A. Hansen, D. Fischer, Y. Ziegler, and A. Closset, Proc. of the 20th European PVSEC (2005) 1529).

Sur le substrat, une texture peut être appliquée par UV-Nil (cf. C. Elsner, J. Dienelt, and D. Hirsch, Microelectronic Engineering 65 (2003) 163) ou par embossing direct (cf M. Worgull, J. F. Hétu, K. K. Kabanemi, and M. Heckele, Microsystem Technologies 12 (2006) 947) pour les substrats souples.

La première couche conductrice 3 est réalisée en oxyde conducteur transparent (par exemple ZnO, ITO) (cf. T. Söderström, F.-J. Haug, O. Cubero, X. Niquille, and C. Ballif, Mater. Res. Soc. Symp. Proc. Volume 1101E, Warrendale, PA, 2008 (2008) 1101), en métal (Ag, Al), ou la combinaison d'une oxyde transparent et d'un métal (cf. A. Banerjee and S. Guha, Journal of Applied Physics 69 (1991) 1030, ou R. H. Franken, R. L. Stolk, H. Li, C. H. M. v. d. Werf, J. K. Rath, and R. E. I. Schropp, Journal of Applied Physics 102 (2007) 014503).

La deuxième couche conductrice 7 est réalisée en oxyde conducteur transparent (par exemple ZnO, ITO, InO, SnO₂, etc.).

Les couches conductrices 3 et 7 sont déposées par les procédés connus de l'homme du métier, tels que évaporation, pulvérisation cathodique, dépôt chimique. De préférence, on utilise pour la première couche conductrice 3 le procédé de pulvérisation cathodique pour les couches conductrices (Ag, oxyde transparent) ou dépôt chimique (exemples : LP-CVD ZnO, AP-CVD SₙO₂) permettant d'obtenir une couche conductrice présentant une morphologie de surface optimale pour la cellule élémentaire inférieure 4. La morphologie peut aussi être donnée par une couche déposée sur le substrat 2 ou embossée directement sur le substrat (cf. C. Elsner, J. Dienelt, and D. Hirsch, Microelectronic Engineering 65 (2003) 163, ou M. Worgull, J. F. Hétu, K. K. Kabanemi, and M. Heckele, Microsystem Technologies 12 (2006) 947).

Les dispositifs photoélectriques élémentaire 4 et 6 peuvent présenter la configuration n-i-p ou n-p. Cela signifie que la première couche déposée pour réaliser la cellule élémentaire est la couche n, puis, éventuellement i, et p. Ceci permet d'utiliser des substrats non transparents ou flexibles. II est bien évident que toutes les combinaisons sont possibles. Notamment lorsque le dispositif comprend deux cellules élémentaires, les quatre combinaisons n-i-p/n-i-p, n-p/n-i-p, n-p/n-p et n-i-p/n-p sont possibles. La combinaison n-i-p/n-i-p est préférée.

Avantageusement, le dispositif photoélectrique élémentaire 4 ou "cellule inférieure", situé du coté du substrat 2 par rapport à la couche intermédiaire 5, est réalisé dans un matériau semiconducteur caractérisé par une bande d'énergie interdite E_{ginf} et le dispositif photoélectrique élémentaire 6 ou "cellule supérieure", situé du coté de la lumière entrant, est réalisé dans un matériau semiconducteur caractérisé par une bande d'énergie interdite E_{gsup}. Préférablement, E_{gsup} est supérieur à E_{ginf} afin d'absorber de manière complémentaire le spectre de la lumière solaire.

Le dispositif photoélectrique élémentaire 4, ou cellule inférieure, est un semiconducteur permettant une application photovoltaïque, et est de préférence à base de silicium. De préférence, il est à base de silicium cristallin, microcristallin ou silicium germanium ou d'un composé de silicium permettant de diminuer le gap par rapport à celui de la cellule supérieure.

Le dispositif photoélectrique élémentaire 6, ou cellule supérieure, est un semiconducteur permettant une application photovoltaïque, de préférence à base de silicium. De préférence, il est à base de silicium amorphe ou d'un composé de silicium permettant d'avoir un gap supérieur à celui du silicium amorphe (par exemple SIC, SiO, etc.). Il présente une épaisseur comprise entre 50 et 400 nm, préférentiellement comprise entre 100 nm et 250 nm.

De préférence, le dispositif photoélectrique élémentaire 4, ou cellule inférieure, est à base de silicium microcristallin et le dispositif photoélectrique élémentaire 6, ou cellule supérieure, est à base de silicium amorphe.

Les cellules élémentaires 4 et 6 sont déposées par les procédés connus de l'homme du métier. De préférence, on utilise un procédé de dépôt chimique en phase vapeur assisté par décharge plasma PECVD (cf. U. Kroll, A. Shah, H. Keppner, J. Meier, P. Torres, D. Fischer, Potential of VHF-Plasmas for Low-Cost Production of a-Si:H Solar Cells, Solar Energy Materials and Solar Cells, Vol 48, pp. 343-350, 1997).

Après le dépôt de la cellule élémentaire inférieure 4, on dépose une couche intermédiaire 5 qui permet de restaurer une morphologie adaptée à la cellule élémentaire supérieure 6.

La couche intermédiaire 5 est constituée d'une couche présentant un indice de réfraction n inférieur à celui des dispositifs photoélectriques élémentaires 4 et 6, généralement en silicium (n=4). De préférence, n est compris entre 1 et 3, et plus préférentiellement encore entre 1,5 et 2,5.

La couche intermédiaire 5 est une couche d'oxyde choisi parmi le groupe comprenant l'oxyde de zinc, des oxydes de silicium dopés, des oxydes de silicium poreux dopés, l'oxyde d'étain, l'oxyde d'indium, l'oxyde de gallium, ainsi que leurs combinaisons. De préférence, on utilise de l'oxyde de zinc transparent.

La couche intermédiaire 5 peut présenter une épaisseur comprise entre 0,1 µm et 100 µm. De préférence, la couche intermédiaire 5 présente une épaisseur comprise entre 0,6 µm et 5 µm, plus préférentiellement entre 1 µm et 3 µm.

Selon une variante de l'invention, la morphologie de surface de la face supérieure 10 de la couche intermédiaire 5, telle que définie ci-dessus, peut être obtenue par la nature même de son procédé de fabrication, c'est-à-dire par croissance de l'oxyde choisi. Pour cela, lors de l'étape de dépôt de la couche intermédiaire 5, on utilise un procédé permettant d'obtenir la morphologie de surface de la face supérieure 10 requise, par croissance de l'oxyde utilisé. Ce procédé utilise l'une des techniques choisies parmi le groupe comprenant CVD basse pression, CVD à pression atmosphérique, pulvérisation cathodique, évaporation, procédé sol gel.

De préférence, la couche intermédiaire 5 est constituée d'une couche de ZnO déposée selon le procédé CVD basse pression (LPCVD) de manière à obtenir la morphologie de surface de la face supérieure requise, par croissance du ZnO (cf. J. Steinhauser, L. Feitknecht, S. Faÿ, R. Schlüchter, A. Shah, C. Ballif, J. Springer, L. Mullerova-Hodakova, A. Purkrt, A. Poruba, and M. Vanecek, Proc.of the 20th European PVSEC (2005) 1608).

Selon une autre variante de l'invention, la morphologie de surface de la face supérieure 10 de la couche intermédiaire 5, telle que définie ci-dessus, peut être obtenue par un traitement de surface postérieur à son dépôt, en utilisant un procédé comprenant, après l'étape de dépôt de la couche intermédiaire 5, une étape supplémentaire de texturation de la face supérieure 10 de la couche intermédiaire 5 de manière à obtenir la morphologie de surface de la face supérieure 10 requise. Cette étape supplémentaire de texturation utilise l'une des techniques choisies parmi le groupe comprenant la gravure, l'attaque chimique, le traitement plasma, le sablage, connues de l'homme du métier.

La cellule "Micromorph" selon l'invention présente une couche intermédiaire dont les faces présentent des morphologies de surface permettant de concilier de manière optimale les morphologies requises par chacune des faces de la couche intermédiaire, et d'obtenir ainsi un dispositif plus performant. En particulier, la cellule élémentaire supérieure 6 bénéficie de la morphologie optimale de la face supérieure 10 de la couche intermédiaire 5, ce qui permet de diffuser et piéger la lumière dans la cellule élémentaire supérieure 6 et de diminuer son épaisseur. Ceci permet de choisir, libéré de toute contrainte, le substrat avec la morphologie optimale pour la cellule inférieure 5. Ainsi seulement, le rendement de la cellule Micromorph peut être maximisé.

La présente description est basée sur un dispositif comprenant deux cellules élémentaires. Il est bien évident que le dispositif selon l'invention peut comprendre plus de deux cellules élémentaires, dont au moins deux cellules sont séparées par une couche intermédiaire selon l'invention.

Les exemples suivants illustrent la présente invention sans toutefois en limiter la portée.

### Exemples:

On compare trois cellules tandems de type "Micromorph" avec configuration n-i-p/n-i-p:
- sans couche intermédiaire (Exemple 1)
- avec une couche intermédiaire standard (Exemple 2), et
- avec une couche intermédiaire selon l'invention (Exemple 3).

Les cellules élémentaires sont composées d'une cellule supérieure 6 en silicium amorphe et d'une cellule inférieure 4 en silicium microcristallin. Ces couches sont déposées préférablement par dépôt chimique en phase vapeur assisté par plasma (PECVD).

Le substrat 2 utilisé est du verre (Schott AF 45) et la texture est donnée par la première couche conductrice 3 (back contact) rugueuse qui est composée d'argent (Ag) déposé par pulvérisation cathodique à haute température (cf. R. H. Franken, R. L. Stolk, H. Li, C. H. M. v. d. Werf, J. K. Rath, and R. E. I. Schropp, Journal of Applied Physics 102 (2007) 014503) et d'une fine couche d'oxyde de Zinc (ZnO) (70 nm) déposée aussi par pulvérisation cathodique et permettant de faire barrière de diffusion entre le contact métallique et les couches photovoltaïques. La cellule supérieure 6 a une épaisseur de 200 nm.

La couche 7 est une couche de ZnO déposée par LP-CVD.

La couche intermédiaire de type standard est constituée par une couche de SiOx de 100 nm déposée par PECVD.

La couche intermédiaire présentant la morphologie selon l'invention est constituée par une couche de ZnO de 1.5 µm déposée par LP-CVD (cf. J. Steinhauser, L. Feitknecht, S. Faÿ, R. Schlüchter, A. Shah, C. Ballif, J. Springer, L. Mullerova-Hodakova, A. Purkrt, A. Poruba, and M. Vanecek, Proc.of the 20th European PVSEC (2005) 1608). Ce procédé permet la croissance d'une couche constituée de surfaces élémentaires présentant la morphologie de surface optimale pour le dépôt de la cellule supérieure.

Les morphologies de surface des faces supérieure et inférieure de la couche intermédiaire selon l'invention sont mesurées selon la méthode décrite ci-dessus. On obtient l'intégrale de la distribution angulaire des deux faces de la couche intermédiaire en question, représentée sur la figure 3. Dans cette figure, les angles sont représentés en abscisse. En ordonnée est représentée la proportion des surfaces élémentaires ayant une inclinaison égale ou inférieure à un angle donné. La courbe C correspond à la face inférieure de la couche intermédiaire et la courbe D correspond à la face supérieure. Pour chaque surface, il est défini un angle α₉₀ qui indique que 90% des surfaces élémentaires de la surface présentent une inclinaison inférieure ou égale à cet angle. Dans le présent exemple, α_{90inf} est égal à 22° et α₉₀ₛᵤₚ est égal à 33°, soit une différence entre α₉₀ₛᵤₚ et α_{90inf} égale à 11°.

A titre de comparaison, les faces supérieure et inférieure de la couche intermédiaire de type standard (Exemple 2) présentent la même morphologie.

On mesure les paramètres suivants sous les conditions standards avec un spectre solaire AM 1.5G: la tension de circuit ouvert (Vco), le facteur de forme (FF), la densité de courant de court-circuit (Jcc) et le rendement (η).

Les résultats obtenus sont indiqués dans le tableau ci-dessous:

| Dispositif | Couche intermédiaire | Jcc (mA/cm²) | Vco (V) | FF | η (%) |
|---|---|---|---|---|---|
| Exemple 1 (comparatif.) | - | 9.5 | 1.27 | 0.737 | 8.9 |
| Exemple 2 (comparatif.) | SiOₓ 100 nm | 10.2 | 1.27 | 0.700 | 9.1 |
| Exemple 3 (Invention) | ZnO-LPCVD 1500 nm | 11.3 | 1.28 | 0.680 | 9.8 |

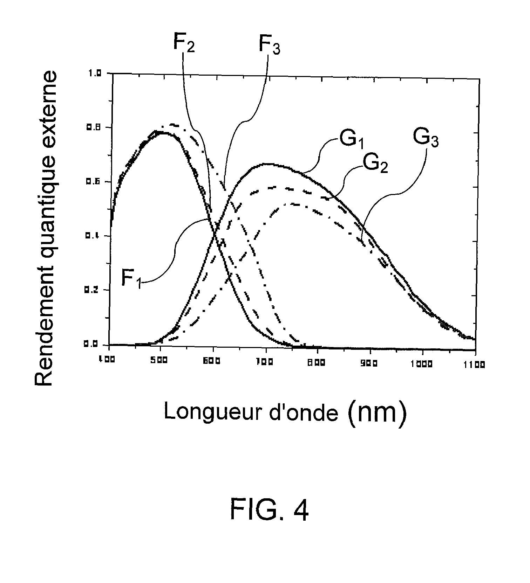

Les rendements quantiques externes des deux cellules sont montrées sur la figure 4, où
- les courbes F1, F2 et F3 représentent le rendement quantique externe de la cellule supérieure pour chacun des exemples 1, 2 et 3 respectivement, et
- les courbes G1, G2 et G3 représentent le rendement quantique externe de la cellule inférieure pour chacun des exemples 1, 2 et 3 respectivement.

Les résultats montrent que le bénéfice obtenu en utilisant une couche intermédiaire présentant la morphologie de surface selon l'invention consiste en une augmentation du courant dans la cellule élémentaire supérieure de 10.2 mA/cm2 à 12.2mA/cm2, soit une amélioration de 19,6%, grâce à la rugosité adaptée à la diffusion de la lumière dans la cellule élémentaire supérieure. L'efficacité de la cellule "Micromorph" augmente de 9.1% pour une cellule avec couche intermédiaire standard à 9.8% pour une cellule avec une couche intermédiaire présentant la morphologie de surface selon l'invention, soit une amélioration de 7.7%. La rugosité rms (root mean square, Ry) de la face supérieur 10 est de 61 nm alors que la rugosité de la face inférieure 11 est de 47 nm.

## Revendications

1. Dispositif photoélectrique (1) à jonctions multiples comprenant un substrat (2) sur lequel est déposée une première couche conductrice (3), au moins deux dispositifs photoélectriques élémentaires (4, 6) de configuration n-i-p ou n-p, sur lesquels est déposée une seconde couche conductrice (7), et au moins une couche intermédiaire (5) prévue entre deux dispositifs photoélectriques élémentaires adjacents (4, 6), **caractérisé en ce que** ladite couche intermédiaire (5) présente, du côté de la lumière entrant, une face supérieure (10) et de l'autre côté, une face inférieure (11), les dites faces supérieure (10) et inférieure (11) présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ est l'angle pour lequel 90% des surfaces élémentaires de la face supérieure (10) de la couche intermédiaire (5) présentent une inclinaison inférieure ou égale à cet angle, et α_{90inf} est l'angle pour lequel 90% des surfaces élémentaires de la face inférieure (11) de la couche intermédiaire (5) présentent une inclinaison inférieure ou égale à cet angle.

2. Dispositif selon la revendication 1, **caractérisé en ce que** α₉₀ₛᵤₚ est compris entre 25° et 50°.

3. Dispositif selon la revendication 1 ou 2, **caractérisé en ce que** α_{90inf} est compris entre 0° et 25°.

4. Dispositif selon l'une quelconque des revendications précédentes, **caractérisé en ce que** le dispositif photoélectrique élémentaire (4), du coté du substrat (2), est à base de silicium microcristallin et **en ce que** le dispositif photoélectrique élémentaire (6), du coté de la lumière entrant, est à base de silicium amorphe.

5. Dispositif selon l'une quelconque des revendications précédentes, **caractérisé en ce que** la couche intermédiaire (5) présente une épaisseur comprise entre 0,6 µm et 5 µm, de préférence entre 1 µm et 3 µm.

6. Dispositif selon l'une quelconque des revendications précédentes, **caractérisé en ce que** la couche intermédiaire (5) est constituée d'une couche présentant un indice de réfraction n inférieur à celui des dispositifs photoélectriques élémentaires (4, 6), n étant compris de préférence entre 1 et 3.

7. Dispositif selon l'une quelconque des revendications précédentes, **caractérisé en ce que** la couche intermédiaire (5) est constituée d'une couche d'oxyde choisi parmi le groupe comprenant l'oxyde de zinc, des oxydes de silicium dopés, des oxydes de silicium poreux dopés, l'oxyde d'étain, l'oxyde d'indium, l'oxyde de gallium ainsi que leurs combinaisons.

8. Dispositif selon la revendication 7, **caractérisé en ce que** la morphologie de surface de la face supérieure (10) de la couche intermédiaire (5) est obtenue lors de la croissance de l'oxyde choisi.

9. Dispositif selon la revendication 8, **caractérisé en ce que** la couche intermédiaire (5) est constituée d'une couche de ZnO déposée par CVD basse pression (LPCVD) de manière à obtenir la morphologie de surface de la face supérieure (10) requise par croissance du ZnO.

10. Dispositif selon l'une quelconque des revendications 1 à 7, **caractérisé en ce que** la morphologie de surface de la face supérieure (10) de la couche intermédiaire (5) est obtenue par traitement de surface postérieur au dépôt de ladite couche intermédiaire (5).

11. Procédé de réalisation d'un dispositif photoélectrique (1) à jonctions multiples comprenant un substrat (2) sur lequel est déposée une première couche conductrice (3), au moins deux dispositifs photoélectriques élémentaires (4, 6) de configuration n-i-p ou n-p, sur lesquels est déposée une seconde couche conductrice (7), **caractérisé en ce qu'**il comprend une étape de dépôt, sur au moins l'un desdits dispositifs photoélectriques élémentaires (4), d'une couche intermédiaire (5) présentant, du côté de la lumière entrant, une face supérieure (10) et de l'autre côté, une face inférieure (11), les dites faces supérieure (10) et inférieure (11) présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ est l'angle pour lequel 90% des surfaces élémentaires de la face supérieure (10) de la couche intermédiaire (5) présentent une inclinaison inférieure ou égale à cet angle, et α_{90inf} est l'angle pour lequel 90% des surfaces élémentaires de la face inférieure (11) de la couche intermédiaire (5) présentent une inclinaison inférieure ou égale à cet angle.

12. Procédé selon la revendication 11, **caractérisé en ce que** la couche intermédiaire (5) est constituée d'une couche d'oxyde choisi parmi le groupe comprenant l'oxyde de zinc, des oxydes de silicium dopés, des oxydes de silicium poreux dopés, l'oxyde d'étain, l'oxyde d'indium, l'oxyde de gallium, ainsi que leurs combinaisons.

13. Procédé selon la revendication 12, **caractérisé en ce que** l'étape de dépôt de la couche intermédiaire (5) utilise un procédé permettant d'obtenir la morphologie de surface de la face supérieure (10) requise par croissance de l'oxyde utilisé.

14. Procédé selon la revendication 13, **caractérisé en ce que** ledit procédé mis en oeuvre lors de l'étape de dépôt de la couche intermédiaire (5) utilise l'une des techniques choisies parmi le groupe comprenant CVD basse pression (LPCVD), CVD haute pression, pulvérisation cathodique, évaporation, et procédé sol gel.

15. Procédé selon les revendications 12 à 14, **caractérisé en ce que** la couche intermédiaire (5) est constituée d'une couche de ZnO et **en ce que** l'étape de dépôt de ladite couche intermédiaire (5) utilise le procédé CVD basse pression (LPCVD) permettant d'obtenir la morphologie de surface de la face supérieure (10) requise par croissance du ZnO.

16. Procédé selon l'une des revendications 11 à 12, **caractérisé en ce qu'**il comprend, après l'étape de dépôt de la couche intermédiaire (5), une étape supplémentaire de texturation de la face supérieure (10) de la couche intermédiaire (5) de manière à obtenir la morphologie de surface de la face supérieure (10) requise.

17. Procédé selon la revendication 16, **caractérisé en ce que** ladite étape supplémentaire de texturation utilise l'une des techniques choisies parmi le groupe comprenant la gravure, l'attaque chimique, le traitement plasma, le sablage.
